(19) Europäisches Patentamt
European Patent Office
Office européen des brevets

(11) **EP 1 624 567 B1**

(12) **EUROPÄISCHE PATENTSCHRIFT**

(45) Veröffentlichungstag und Bekanntmachung des Hinweises auf die Patenterteilung:
**20.01.2010 Patentblatt 2010/03**

(51) Int Cl.:
*H03K 5/24* (2006.01)      *H03K 5/08* (2006.01)
*G01R 19/165* (2006.01)   *G05F 3/26* (2006.01)
*H03M 1/36* (2006.01)

(21) Anmeldenummer: **05016721.2**

(22) Anmeldetag: **02.08.2005**

(54) **Spannungskomparator**

Voltage comparator

Comparateur de tensions

(84) Benannte Vertragsstaaten:
**DE FR**

(30) Priorität: **06.08.2004   DE 102004038552**

(43) Veröffentlichungstag der Anmeldung:
**08.02.2006   Patentblatt 2006/06**

(73) Patentinhaber: **Atmel Automotive GmbH**
**74072 Heilbronn (DE)**

(72) Erfinder:
• **Gruber, Berthold**
**74906 Bad Rappenau (DE)**

• **Hehn, Lars**
**74080 Heilbronn (DE)**

(74) Vertreter: **Müller, Wolf-Christian**
**Koch Müller**
**Patentanwaltsgesellschaft mbH**
**Maaßstrasse 32/1**
**69123 Heidelberg (DE)**

(56) Entgegenhaltungen:
**EP-A- 0 669 717        DE-A1- 19 911 098**
**US-A- 5 136 184        US-A- 5 446 397**
**US-A- 5 512 849        US-A- 6 037 890**
**US-A1- 2001 013 799   US-A1- 2001 035 777**

**Beschreibung**

Die vorliegende Erfindung betrifft einen Spannungskomparator.

Spannungskomparatoren haben die Aufgabe, eine Vergleichsspannung mit einer Referenzspannung zu vergleichen und das Ergebnis dieses Vergleiches am Ausgang möglichst trägheitslos zu signalisieren. Analogkomparatoren wirken als Schnittstelle zwischen analogen und digitalen Funktionseinheiten. Das amplitudenanaloge Eingangssignal (Spannung) wird in ein binäres Ausgangssignal (Spannung) umgewandelt. Am Ausgang tritt entweder H-Pegel (High-Pegel, hohes Potential) oder L-Pegel (Low-Pegel, niedriges Potential) auf. Komparatorschaltkreise sind beispielsweise spezielle Verstärker, die entsprechend den Operationsverstärkern einen $_{Diff}$erenzeingang und einen unsymmetrischen Ausgang aufweisen können. Die Ausgangsstufe des Komparators ist meist so ausgelegt, dass sie mit den Logikpegeln mehrerer digitaler Schaltkreisfamilien kompatibel ist. Das bedeutet, dass digitale Schaltkreise ohne Zwischenschalten weiterer Elemente vom Komparatorausgang ansteuerbar sind. Komparatoren können dabei ohne und mit Rückkopplung (Hysterese) betrieben werden.

Typische Komparatoranwendungen sind Schwellwertschalter (Pegeldetektoren), Fensterdiskriminatoren, Gleichrichterschaltungen für kleine Signale, Schmitt-Trigger und andere Kippschaltungen, die u.a. zur Flankenversteilerung und zur Umwandlung zeitveränderlicher, beispielsweise sinusförmiger Spannungen in eine Rechteckfolge angewendet werden.

Das Dokument US-A-5512849 (Wong) offenbart einen Spannungskomparator zum Vergleich einer Vergleichsspannung mit einer Schwelle,

- mit einem ersten Spannungs-Strom-Wandler zur Wandlung einer die Schwelle bestimmenden Referenzspannung in einem von der Referenzspannung abhängigen Referenzstrom,
- mit einem zweiten Spannungs-Strom-Wandler zur Wandlung der Vergleichsspannung in einen von der Vergleichsspannung abhängigen Vergleichsstrom,
- mit einer Ausgangsstufe zur Ausgabe eines digitalen Ausgangspegels, wobei der Ausgangspegel von dem Referenzstrom und dem Vergleichsstrom abhängig ist,
- bei dem die Ausgangsstufe mit einem Stromsummationsknoten verbunden ist, in dem sich von den Strömen abgeleitete weitere Ströme summieren, wobei einer der weitere Ströme als negativer Wert in die Summation eingeht,
- mit einem Spannungsbegrenzungsmittel,
- bei dem ein zweiter Transistor mit dem zweiten Spannungs-Strom-Wandler verbunden ist, wobei der Zweite, als Spannungsbegrenzungsmittel wirkender Transistor gegenüber der Ausgangsstufe eine höhere Durchbruchsspannungsfestigkeit aufweist.

Das Dokument DE19911098 A1 (NEC Corp.) offenbart mit Hinweis zu Figur 2 einen Spannungskomparator mit einem ersten und einem zweiten Spannungs-Strom-Wandler, die mit einem Stromsummationsknoten verbunden sind.

Aufgabe der vorliegenden Erfindung ist es, einen Spannungskomparator anzugeben, der möglichst im Automobilbereich einsetzbar ist. Diese Aufgabe wird durch den Spannungskomparator mit den Merkmalen des Anspruchs 1 gelöst. Günstige Weiterbildungen und Ausgestaltungsformen sind jeweils Gegenstand von Unteransprüchen.

Das Wesen der Erfindung besteht darin, anstelle eines Differenzverstärkers eine Komparatorfunktion durch zu vergleichende Ströme bereitzustellen. Demzufolge ist ein Spannungskomparator zum Vergleich einer Vergleichsspannung mit einer Schwelle vorgesehen. Der Spannungskomparator weist dabei einen ersten Spannungs-Strom-Wandler zur Wandlung einer die Schwelle bestimmenden Referenzspannung in einen von der Referenzspannung abhängigen Referenzstrom auf. Im einfachsten Fall ist die Referenzspannung eine konstante Spannung, beispielsweise eine Zehnerspannung oder Versorgungsspannung. Bevorzugt ist die Referenzspannung jedoch eine einstellbare Spannung, beispielsweise eine analoge Ausgangsspannung eines Mikrocontrollers. Um den Referenzstrom zu generieren, wirkt der erste Spannungs-Strom-Wandler an seinem Ausgang vorteilhafterweise wie eine referenzspannungsabhängige Stromquelle mit einem Innenwiderstand.

Für den Spannungskomparator ist ein zweiter Spannungs-Strom-Wandler zur Wandlung der Vergleichsspannung in einen von der Vergleichsspannung abhängigen Vergleichsstrom erforderlich. Hinsichtlich des Vergleichsstromes wirkt der zweite Spannungs-Strom-Wandler an seinem Ausgang vorteilhafterweise wie eine vergleichsspannungsabhängige Stromquelle mit Innenwiderstand.

Weiterhin weist der Spannungskomparator eine Ausgangsstufe zur Ausgabe eines digitalen Ausgangspegels auf, wobei der Ausgangspegel von dem Referenzstrom und dem Vergleichsstrom abhängig ist. Die Abhängigkeit des Ausgangspegels bildet dabei die Komparatorfunktion ab, indem beispielsweise ein erster Ausgangspegel (high) einer Vergleichsspannung oberhalb einer ersten Schwelle zugeordnet ist und ein zweiter Ausgangspegel (low) einer Vergleichsspannung unterhalb einer zweiten Schwelle zugeordnet ist, wobei die erste und die zweite Schwelle gleich oder unterschiedlich sein können und beispielsweise eine Funktion eines Fensterkomparators abbilden.

Die Erfindung sieht vor, dass die Ausgangsstufe mit einem Stromsummationsknoten verbunden ist, in dem sich der Vergleichsstrom und ein von dem Referenzstrom abhängiger Schwellenstrom summieren, wobei einer der beiden Ströme als negativer Wert in die Summation eingeht. Die Summe der in den Stromsummationsknoten hinein und heraus fließenden Ströme ist dabei stets null. Die Beziehung der Abhängigkeit zwischen dem Schwellenstrom und dem Referenzstrom ist dabei durch eine mathematische Funktion gegeben.

In einer Weiterbildung der Erfindung sind Mittel zur Multiplikation des Referenzstromes mit einem Multiplikationsfaktor vorgesehen, so dass der mittels des Multiplikationsfaktors generierte Schwellenstrom in die Summation im Stromsummationsknoten eingeht. Beispielsweise kann zum Vervielfachen des Stromes ein mehrfaches des Referenzstromes zum Schwellenstrom mittels NMOS- oder PMOS-Transistoren geschalten werden. Zur Weiterbildung der Erfindung ist hierzu ein Referenzstromspiegel vorgesehen, dessen Stromspiegelverhältnis als Mittel zur Multiplikation einstellbar, insbesondere schaltbar ist. Beispielsweise können mehrere Transistoren, die den gespiegelten Strom des Referenzstromspiegels steuern parallel geschalten sein. Zur Einstellung des Multiplikationsfaktors werden einer oder mehrere dieser steuernden Transistoren aktiviert beziehungsweise deaktiviert, indem beispielsweise deren Gate-Potential verändert wird.

Eine bevorzugte Ausgestaltung der Erfindung sieht vor, dass der Ausgangspegel durch ein Potential im Stromsummationsknoten bestimmt ist, das von dem Vergleichsstrom und dem Schwellenstrom abhängig ist. Bevorzugt ist der Spannungskomparator dabei derart dimensioniert, dass sich das Potential im Stromsummationsknoten in dem Bereich signifikant ändert, in dem Werte des Vergleichsstroms und des Schwellenstroms nahe beieinander liegen. Bevorzugt ist das Potential im Stromsummationsknoten dabei unabhängig von elektrischen Eigenschaften der Ausgangsstufe, diese weist hierzu vorteilhafterweise einen hochohmigen Eingang auf.

Vorzugsweise werden die Ausgangstufe und nachfolgende digitale Auswerteschaltkreise und vorzugsweise auch der die Spannungsreferenz generierende Schaltkreis mit Transistoreigenschaften für geringe Durchbruchspannungen von 10V hergestellt. Geringe Durchbruchspannungen ermöglichen eine kleine Strukturbreite, die eine hohe Integrationsdichte insbesondere für digitale Auswerteschaltungen oder Kommunikationsschaltungen ermöglicht. Erfindungsgemäß ist daher ein Spannungsbegrenzungsmittel zur Begrenzung der zwischen dem Stromsummationsknoten und dem Masseanschluss liegenden Spannung vorgesehen.

Ein Beispiel für ein derartiges Spannungsbegrenzungsmittel ist eine entsprechend mit dem Stromsummationsknoten und dem Masseanschluss verbundene Zehnerdiode. Oberhalb der Zehnerspannung fließt durch die Zehnerdiode ein zusätzlicher Zehnerstrom aus dem Stromsummationsknoten. Ohne einen Zehnerstrom ist erfindungsgemäß vorgesehen, dass der Stromsummationsknoten über zumindest einen (zweiten) Transistor mit einem, mit dem zweiten Spannungs-Strom-Wandler verbundenen Stromspiegel verbunden ist. Dabei weist dieser, als Spannungsbegrenzungsmittel wirkende Transistor gegenüber der Ausgangsstufe eine höhere Durchbruchsspannungsfestigkeit auf. Insbesondere die hohe Durchbruchsspannungsfestigkeit dieses Transistors ermöglicht die Verwendung des Spannungskomparator als integrierter Bestandteil in einer Schaltung in einer sogenannten Smart-Power-Technologie für den Einsatz in einem Kraftfahrzeug mit einer 42V Bordnetzspannung. Vorzugsweise weist dieser Transistor hierzu eine Durchbruchsspannungsfestigkeit von 80V auf.

Der als Spannungsbegrenzungsmittel wirkende Transistor ist hierbei vorzugsweise als Emitterfolger geschaltet. So ist vorteilhafterweise das Gate beziehungsweise die Basis dieses Transistors mit der Versorgungsspannung der Ausgangsstufe verbunden oder verbindbar.

Werden auch Referenzspannungen größer als die maximal zulässige Spannung in der Ausgangsstufe benötigt, ist in einer vorteilhaften Ausgestaltung der Erfindung vorgesehen, dass der Stromsummationsknoten über einen anderen Transistor mit dem ersten Spannungs-Strom-Wandler verbunden ist, wobei dieser, als Spannungsbegrenzungsmittel wirkende Transistor ebenfalls gegenüber der Ausgangsstufe eine höhere Durchbruchsspannungsfestigkeit aufweist. Vorzugsweise ist ebenfalls das Gate beziehungsweise die Basis dieses Transistors mit der Versorgungsspannung der Ausgangsstufe verbunden oder verbindbar.

Eine vorteilhafte Ausgestaltung der Erfindung sieht vor, dass der erste Spannungs-Strom-Wandler und der zweite Spannungs-Strom-Wandler auf einem Halbleiterchip zueinander benachbart oder ineinander gesetzt angeordnet sind. Dies bewirkt, dass beide Wandler im wesentlichen der selben Betriebstemperatur in diesem Bereich des Halbleiterchips ausgesetzt sind. Zudem sind die Auswirkungen von Fertigungstoleranzen, die über die Gesamtfläche eines Halbleiterchips auftreten in diesem Bereich der benachbarten oder ineinander verschachtelten Wandler nur gering. Dieses so genannte "matching" der beiden Wandlerstrukturen auf dem Halbleiterchip wird besonders vorteilhaft angewendet, indem der erste Spannungs-Strom-Wandler und der zweite Spannungs-Strom-Wandler gleiche Bauelemente aufweisen. Dies ermöglicht ein sehr ähnliches Verhalten der beiden Wandler auf physikalische Effekte, wie Temperaturänderungen oder mechanische Spannungen.

Eine bevorzugte und besonders einfache Ausgestaltung der Erfindung wird realisiert, indem zumindest einer der beiden Spannungs-Strom-Wandler einen Stromspiegel mit zumindest einem in Reihe geschaltenen Widerstand aufweist. Mit der Annahme im wesentlichen linearer Widerstände kann demzufolge oberhalb einer oder mehrerer Thresholdspannungen des Stromspiegels ein im wesentlichen lineares Verhalten des Spannungs-Strom-Wandler angenommen werden. Für Spannungen unterhalb der Thresholdspannung verbleibt der Spannungs-Strom-Wandler inaktiv, so dass nur ein sehr geringer Ruhestrom im inaktiven Zustand benötigt wird.

Bevorzugt ist in einer Ausgestaltungsvariante der Erfindung vorgesehen, dass zusätzlich zum Referenzstrom und zum Vergleichstrom Mittel zur Generierung eines, vorzugsweise vom Referenzstrom abhängigen Querstroms vorgesehen sind, wobei der Querstrom einmal negativ und einmal positiv in die Summation im Stromsummationsknoten eingeht.

Ändert sich die Vergleichsspannung im Bereich der Schwelle in einem Zeitbereich nur sehr langsam, ändert sich das Potential unter Umständen ebenfalls nur langsam zwischen dem binären Wert 0 und dem binären Wert 1. Vorzugsweise weist daher die Ausgangsstufe einen Schmitt-Trigger auf, dessen Eingang mit dem Stromsummationsknoten verbunden ist.

Die Vergleichsspannung kann beispielsweise zwischen einem Eingang und einem Masseanschluss des Spannungskomparators anliegen. Hiervon abweichend ist jedoch in einer bevorzugten Ausgestaltung der Erfindung vorgesehen, dass die Vergleichsspannung eine an zwei Eingängen des Spannungskomparators anliegende Differenzspannung ist. Die Differenzspannung kann dabei von einer an beiden Eingängen anliegenden Gleichtakteingangsspannung signifikant abweichen.

Die Erfindung weiterbildend ist vorteilhafterweise vorgesehen, dass der zweite Spannungs-Strom-Wandler zur Wandlung einer positiven und einer negativen Differenzspannung ausgebildet ist, wobei der zweite Spannungs-Strom-Wandler hierzu vorzugsweise einen ersten, der positiven Differenzspannung zugeordneten Stromspiegel und einen zweiten, der negativen Differenzspannung zugeordneten Stromspiegel aufweist.

Um in ein Strommanagement eines Kraftfahrzeugs auch den Komparator einzubeziehen, ist vorteilhafterweise ein Mittel zur Abschaltung der Versorgungsspannung der Ausgangsstufe vorgesehen, so dass der Spannungskomparator zwischen einem Schlafmodus und einem Betriebsmodus schaltbar ist.

Ein besonderer Aspekt der Erfindung ist eine Verwendung eines zuvor beschriebenen Spannungskomparators innerhalb einer Schaltung zur Auswertung und/oder Überwachung einer, mittels einer Ladungspumpe generierten Spannung.

Ein weiterer Aspekt der Erfindung ist ein Analog-Digital-Umsetzer insbesondere nach dem Wägeverfahren oder nach dem Zählverfahren zur Umsetzung von einem zeitlichen Vergleichsspannungsverlauf in digitale Ausgangssignale mit einem zuvor beschriebenen Spannungskomparator.

Die Erfindung soll nachfolgend durch Ausführungsbeispiele im Zusammenhang mit zwei schematisierten Zeichnungen erläutert werden.

Im Einzelnen zeigt

Fig. 1 ein schematisches Blockschaltplan des Spannungskomparators; und
Fig. 2 einen Schaltplan des Spannungskomparators auf Transistorlevel.

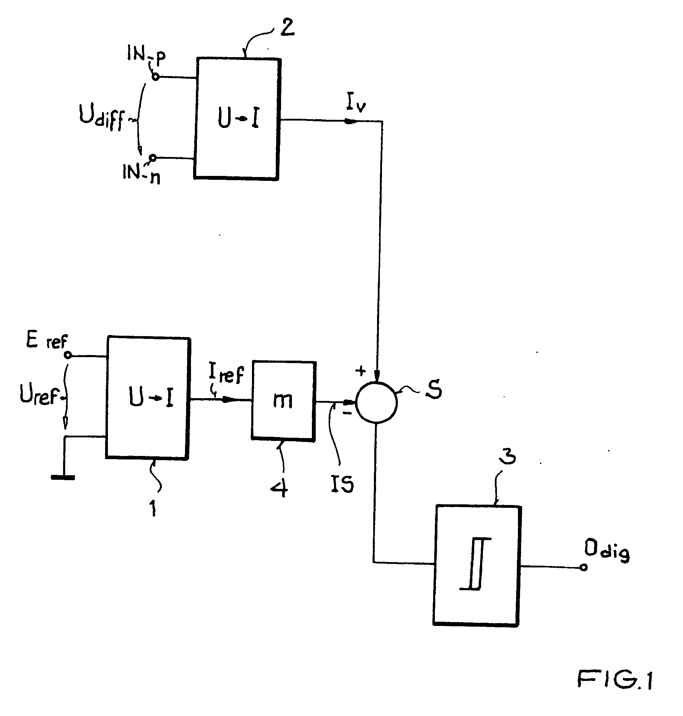

In Fig. 1 ist ein Blockschaltplan eines Spannungskomparators dargestellt. Der Spannungskomparator weist einen ersten Spannungs-Strom-Wandler 1 auf, der eine Referenzspannung $U_{ref}$ am Eingang $E_{ref}$ in den Strom $I_{ref}$ wandelt. In dem dargestellten Ausführungsbeispiel zeigt die Stromrichtung des Referenzstromes $I_{ref}$ aus dem Spannungs-Strom-Wandler 1 heraus. Die Referenzspannung $U_{ref}$ ist dabei auf den Masseanschluss bezogen.

Dem ersten Spannungs-Strom-Wandler 1 ist ein Multiplikator 4 nachgeschalten, der den Referenzstrom $I_{ref}$ mit dem Multiplikationsfaktor m multipliziert. Der Multiplikationsfaktor m ist vorzugsweise von 0,5 bis 10 in Stufen einstellbar. Wiederum vom Referenzstrom $I_{ref}$ abhängig ist der Schwellenstrom Is. Die Abhängigkeit ist im dargestellten Ausführungsbeispiel der Figur 1 durch den Multiplikationsfaktor m gegeben, so dass unter Vernachlässigung des Einflusses durch einem Vergleichsstrom $I_v$ gilt

$$I_s = m \, {}^* \, I_{ref}$$

Weiterhin ist ein zweiter Spannungs-Strom-Wandler 2 vorgesehen, der eine an den Eingängen $IN_{-p}$ und $IN_{-n}$, anliegende Differenzspannung $U_{diff}$ in den Vergleichsstrom $I_v$ wandelt. Der zweite Spannungs-Strom-Wandler 2 ist mit seinem Ausgang mit einem Stromsummationsknoten S verbunden. Ebenfalls ist der Multiplikator 4 mit dem Stromsummationsknoten S verbunden, wobei in diesem Ausführungsbeispiel der Vergleichsstrom $I_v$ mit positiven Vorzeichen in den Stromsummationsknoten S hineinfließt, während der der Schwellenstrom $I_s$ negativ in die Summation im Stromsummationsknoten S eingeht.

Weiterhin ist der Stromsummationsknoten S mit einer Ausgangsstufe 3 verbunden, deren Schmitt-Trigger-Eingang hochohmig ist, so dass der in die Ausgangsstufe 3 fließende Strom vernachlässigt werden kann. Da die Summe aller Ströme, die in den Stromsummationsknoten S hineinbeziehungsweise herausfließen gleich Null sein muss, ist in dem schematisch dargestellten Ausführungsbeispiel der Schwellenstrom $I_s$ gleich dem Vergleichsstrom $I_v$.

Für einen niedrigen Vergleichsstrom $I_v$ wird der Stromfluss durch den Stromsummationsknoten S durch den Vergleichsstrom $I_v$ bestimmt. Der erste Multiplikator 4 wirkt daher als Stromsenke, die jedoch einen größeren Strom aufnehmen kann als durch den Vergleichsstrom $I_v$ zufließt. Demzufolge ist in diesem Zustand die Spannung vom Stromsummationsknoten S gegenüber Masse gering und unterhalb der Schwellen des Schmitt-Triggers der Ausgangsstufe 3. Steigt der Vergleichsstrom $I_v$ weiter an, gelang dieser in jene Größenordnung, die durch den als Stromsenke wirkenden Multiplikator 4 aufgenommen werden kann. Mit Erreichen dieser Schwelle ist der Strom auf einen von der Referenzspannung $U_{ref}$ abhängigen

Wert des Schwellenstromes $I_s$ begrenzt.

Wird die Differenzspannung $U_{diff}$ weiter erhöht, verbleibt der durch den Stromsummationsknoten S fließende Strom im wesentlichen konstant. Dadurch, dass der zweite Spannungs-Strom-Wandler 2 als Stromquelle mit einem Innenwiderstand wirkt, steigt die Spannung im Stromsummationsknoten S signifikant an und überschreitet die Schwellen des Schmitt-Triggers der Ausgangsstufe 3. Um den Spannungskomparator für hohe Bordnetzspannungen eines Kraftfahrzeugs zu nutzen, weist der zweite Spannungs-Strom-Wandler 2 eine hohe Durchbruchsspannungsfestigkeit auf, die vorzugsweise bei 80 V oder höher liegt.

Dieser zweite Spannungs-Strom-Wandler 2 ist demzufolge vorteilhafterweise derart hochspannungsfest ausgebildet, dass dieser eine Durchbruchsspannungsfestigkeit aufweist, die signifikant über den Spannungswerten der Versorgungsspannung VP der Ausgangsstufe 3 oder der maximalen Referenzspannung Uref liegt und an eine, an den zwei Eingängen $IN_{-p}$ und $IN_{-n}$ anlegbare maximale Gleichtakteingangsspannung angepasst ist.

Die Ausgangssignale der Ausgangsstufe 3 sind binäre, digitale Rechtecksignale mit den Zuständen "high" und "low", wobei in dem Ausführungsbeispiel der Fig. 1 eine Differenzspannung $U_{diff}$ oberhalb der von der Referenzspannung $U_{ref}$ abhängigen Schwelle des Spannungskomparators ein "high"-Signal und einer Differenzspannung $U_{diff}$ unterhalb der von der Referenzspannung $U_{ref}$ abhängigen Schwelle des Komparators ein "low"-Signal zugeordnet ist.

Die Ausgangsstufe 3 des Komparators ist so ausgelegt, dass sie mit den Logikpegeln vorzugsweise mehrerer Schaltkreisfamilien kompatibel ist. Das bedeutet, dass digitale Schaltkreise ohne Zwischenschalten weiterer Elemente vom Komparatorausgang ansteuerbar sind. Abweichend von der Darstellung der Fig.1 ist der Komparatorausgang vorteilhafterweise mittels eines Strobe-Anschlusses abschaltbar. Bei abgeschaltetem Ausgang ist der Ausgang hochohmig. Das hat insbesondere den Vorteil, dass mehrere Komparatoren sich auf eine gemeinsame Bus-Leitung schalten lassen. Hierbei wird stets nur ein Ausgang aktiviert, die übrigen sind hochohmig und beeinflussen den Ausgang des angeschlossenen aktiven Komparators nicht.

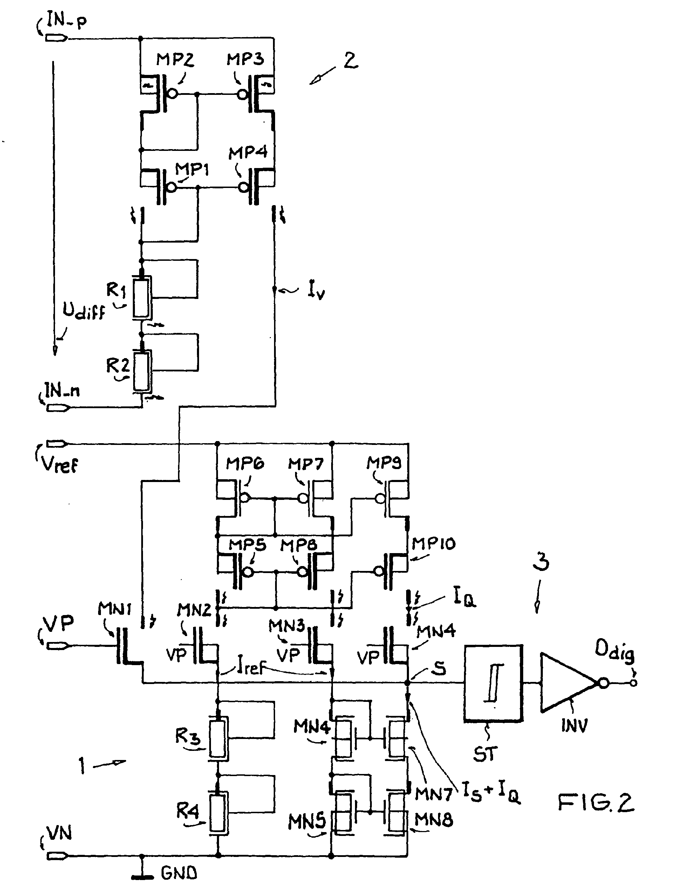

Die Figur 2 zeigt ein Ausführungsbeispiel der Erfindung auf TransistorLevel. Der erste Strom-Spannungs-Wandler 1 und der zweite Strom-Spannungs-Wandler 2 weisen jeweils zwei Widerstände R3, R4 und R1, R2 auf, die mit einem Stromspiegel, bestehend aus den PMOS-Transistoren MP5 bis MP8 beziehungsweise MP1 bis MP4, in Reihe geschalten sind. Übersteigt die Differenzspannung $U_{diff}$ beziehungsweise die Referenzspannung $U_{ref}$ die zweifache Threshold-Spannung, beginnt ein Strom durch die PMOS-Transistoren MP5 bis MP8 beziehungsweise MP1 bis MP4 und durch die Widerstände R3, R4 beziehungsweise R1, R2 zu fließen. Dieser Strom wird mittels der jeweiligen Stromspiegel gespiegelt. Zudem weist die Schaltung der Fig. 2 einen schaltbaren Stromspiegel aus NMOS-Transistoren MN4, MN 5, MN7, MN8 auf. Mittels in Fig. 2 nicht dargestellter Schalttransistoren kann das Spiegelverhältnis des schaltbaren Stromspiegels verändert werden.

Die PMOS-Transistoren MP5 bis MP8 und die Widerstände R3, R4 des ersten Spannungs-Strom-Wandlers 1 und die PMOS-Transistoren MP1 bis MP4 und die Widerstände R1, R2 des zweiten Spannungs-Strom-Wandlers 2 stimmen dabei im wesentlichen überein. Die entsprechenden PMOS-Transistoren MP1 zu MP5 usw. weisen hierzu dasselbe Aspektverhältnis auf. Ebenfalls sind die Widerstände R1 bis R4 durch denselben Technologieschritt entstanden. Weiterhin ist es besonders vorteilhaft ein gutes, so genanntes "matching" zu erreichen, indem diese PMOS-Transistoren MP1 bis MP8 und Widerstände R1 bis R4 zueinander benachbart angeordnet oder in einander verschachtelt angeordnet sind. Dies bewirkt, dass diese Schaltungsteile im wesentlichen dasselbe Verhalten für unterschiedliche Betriebstemperaturen aufweisen.

Um eine Einsatzmöglichkeit für ein 42V Bordnetz eines Kraftfahrzeugs zu erhalten sind zumindest die PMOS-Transistoren MP1 bis MP4 als Hochvolt-PMOS-Transistoren mit einer Durchbruchsspannungsfestigkeit von 80V ausgelegt. Die Ausgangsstufe 3 weist einen Schmitt-Trigger ST und einen, mit dem Ausgang $O_{dig}$ des Spannungskomparators verbundenen Inverter INV auf. Der eine Versorgungsspannungsanschluss VN liegt auf Masse GND, während der andere Versorgungsspannungsanschluss VP auf einem Versorgungsspannungspotential von 5 V liegt, mit dem auch nachfolgende, in Fig. 2 nicht dargestellte digitale Schaltkreise versorgt werden. Die maximale Durchbruchsspannungsfestigkeit des Schmitt-Triggers ST ist in Bezug auf die Versorgungsspannung VP von 5V ausgelegt, und erreicht beispielsweise Werte zwischen 8V und 10V.

Versucht der zweite Spannungs-Strom-Wandler 2 einen großen Strom $I_V$ zu treiben, würden die über 10V hinausgehenden Spannungen die Eingangstransistoren des Schmitt-Triggers ST zerstören. Um die im Stromsummationsknoten S auftretende Spannung zu begrenzen ist der NMOS-Transistor MN1 vorgesehen, der eine Durchbruchsspannungsfestigkeit aufweist, die zumindest der eines der Transistoren MP1 bis MP4 entspricht. Da dieser NMOS Transistor MN1 als Source-Folger geschalten ist, beträgt das maximale Potential am Source-Anschluss das Versorgungsspannungspotential VP weniger der Thresholdspannung des Transistors MN1, sofern ein Strom von der Drain zur Source fließt. Übersteigt die Referenzspannung Uref ebenfalls die Versorgungsspannung VP signifikant, können, wie in Fig. 2 dargestellt, weitere NMOS-Transistoren MN2, MN3 oder MN6 als Begrenzungsmittel vorgesehen sein. Weiterhin können die Transistoren MN1, MN2, MN3 oder MN6 auch dazu dienen die Ströme $I_V$, $I_{ref}$, $I_Q$ zuzuschalten oder abzuschalten.

Die Referenzspannung $U_{ref}$ wird in diesem Ausführungsbeispiel von Außen an den Spannungskomparator angelegt. Vorzugsweise sind die Bauelemente des Spannungskomparators auf einem Halbleiterchip integriert, wobei die Referenzspannung $U_{ref}$ an einen Anschluss des Halbleiterchips anschließbar ist. Alternativ ist es natürlich auch möglich die Referenzspannung $U_{ref}$ innerhalb des Spannungskomparators zu generieren.

Neben dem Vergleichsstrom $I_v$ und dem Schwellenstrom Is geht ein weiterer Strom $I_Q$ in die Summation im Stromsummationsknoten S ein. Dieser Strom kann als Querstrom $I_Q$ bezeichnet werden, der sowohl positiv als auch negativ in die Stromsummation im Stromsummationsknoten S eingeht und damit durch den Stromsummationsknoten S lediglich hindurch fließt. In dem Ausführungsbeispiel der Fig. 2 ist der Querstrom $I_Q$ vom Referenzstrom $I_{ref}$ gespiegelt.

**Bezugszeichenliste**

| | |
|---|---|
| 1, 2 | Spannungs-Strom-Wandler |
| 3 | Ausgangsstufe |
| 4 | Multiplikator |
| $U_{diff}$ | Differenzspannung |
| $IN_{-p}$) $IN_{-n}$ | Komparatoreingänge |
| $U_{ref}$ | Referenzspannung |
| $E_{ref}$ | Eingang der Referenzspannung |
| $I_v$ | Vergleichsstrom |
| $I_{ref}$ | Referenzstrom |
| $I_s$ | Schwellenstrom |
| S | Stromsummationsknoten |
| $O_{dig}$ | Komparatorausgang |
| VP | Versorgungsspannungsanschluss 5V |
| VN, GND | Masse |
| MP1 bis MP10 | PMOS-Transistor |
| MN1 bis MN8 | NMOS-Transistor |
| R1 bis R4 | Widerstand |
| $I_Q$ | Querstrom |
| ST | Schmitt-Trigger |
| INV | Inverter |

**Patentansprüche**

1. Spannungskomparator zum Vergleich einer Vergleichsspannung ($U_{diff}$) mit einer Schwelle,

   - mit einem ersten Spannungs-Strom-Wandler (1) zur Wandlung einer die Schwelle bestimmenden Referenzspannung ($U_{ref}$) in einen von der Referenzspannung ($U_{ref}$) abhängigen Referenzstrom ($I_{ref}$),
   - mit einem zweiten Spannungs-Strom-Wandler (2) zur Wandlung der Vergleichsspannung ($U_{diff}$) in einen von der Vergleichsspannung ($U_{diff}$) abhängigen Vergleichsstrom ($I_V$),
   - mit einer Ausgangsstufe (3) zur Ausgabe eines digitalen Ausgangspegels, wobei der Ausgangspegel von dem Referenzstrom ($I_{ref}$) und dem Vergleichsstrom ($I_V$) abhängig ist,
   - bei dem die Ausgangsstufe (3) mit einem Stromsummationsknoten (S) verbunden ist, in dem sich der Vergleichsstrom ($I_V$) und ein von dem Referenzstrom ($I_{ref}$) abhängiger Schwellenstrom ($I_S$) summieren, wobei einer der beiden Ströme ($I_S$, $I_V$) als negativer Wert in die Summation eingeht,
   - mit einem Spannungsbegrenzungsmittel (MN1, MN6) zur Begrenzung der zwischen dem Stromsummationsknoten (S) und dem Masseanschluss (GND, VN) der Ausgangsstufe (3) liegenden Spannung,
   - bei dem der Stromsummationsknoten (S) über einen Transistor (MN1) mit dem zweiten Spannungs-Strom-Wandler (2) verbunden ist, wobei der, als Spannungsbegrenzungsmittel wirkende Transistor (MN1) gegenüber der Ausgangsstufe (3) eine höhere Durchbruchsspannungsfestigkeit aufweist.

2. Spannungskomparator nach Anspruch 1, **gekennzeichnet durch** Mittel zur Multiplikation des Referenzstromes ($I_{ref}$) mit einem Multiplikationsfaktor (m), so dass der in die Summation im Stromsummationsknoten (S) eingehende Schwellenstrom ($I_S$) von dem Multiplikationsfaktor (m) und von dem Referenzstrom ($I_{ref}$) abhängig ist.

3. Spannungskomparator nach Anspruch 2, **gekennzeichnet durch** einen Referenzstromspiegel (MN4, MN5, MN7, MN8), dessen Stromspiegelverhältnis als Mittel zur Multiplikation einstellbar, insbesondere schaltbar ist.

4. Spannungskomparator nach einem der vorhergehenden Ansprüche , **dadurch gekennzeichnet, dass** der Ausgangspegel durch ein Potential im Stromsummationsknoten (S) bestimmt ist, das von dem Vergleichsstrom ($I_V$) und dem Schwellenstrom ($I_S$) abhängig ist.

5. Spannungskomparator nach einem der vorhergehenden Ansprüche, **dadurch gekennzeichnet, dass** der Stromsummationsknoten (S) über zumindest einen weiteren Transistor (MN6) mit einem mit dem ersten Spannungs-Strom-Wandler (1) verbundenen Stromspiegel verbunden ist, wobei der weitere, als Spannungsbegrenzungsmittel wirkende Transistor (MN6) gegenüber der Ausgangsstufe (3) eine höhere Durchbruchsspannungsfestigkeit aufweist.

**6.** Spannungskomparator nach Anspruch 5,
**dadurch gekennzeichnet, dass**
das Gate beziehungsweise die Basis des weiteren Transistors (MN6) mit der Versorgungsspannung (VP) der Ausgangsstufe (3) verbunden oder verbindbar ist.

**7.** Spannungskomparator nach einem der vorhergehenden Ansprüche,
**dadurch gekennzeichnet, dass**
das Gate beziehungsweise die Basis des zweiten Transistors (MN1) mit der Versorgungsspannung (VP) der Ausgangsstufe (3) verbunden oder verbindbar ist.

**8.** Spannungskomparator nach einem der vorhergehenden Ansprüche,
**dadurch gekennzeichnet, dass**
der erste Spannungs-Strom-Wandler (1) und der zweite Spannungs-Strom-Wandler (2) auf einem Halbleiterchip zueinander benachbart oder ineinander gesetzt angeordnet sind.

**9.** Spannungskomparator nach einem der vorhergehenden Ansprüche,
**dadurch gekennzeichnet, dass**
der erste Spannungs-Strom-Wandler (1) und der zweite Spannungs-Strom-Wandler (2) gleiche Bauelemente aufweisen.

**10.** Spannungskomparator nach einem der vorhergehenden Ansprüche,
**dadurch gekennzeichnet, dass**
der erste Spannungs-Strom-Wandler (1) einen Stromspiegel mit zumindest einem in Reihe geschalteten Widerstand (R3, R4) aufweist, und/oder der zweite Spannungs-Strom-Wandler (2) einen Stromspiegel mit zumindest einem in Reihe geschalteten Widerstand (R1, R2) aufweist.

**11.** Spannungskomparator nach einem der vorhergehenden Ansprüche,
**gekennzeichnet durch**
Mittel zur Generierung eines, vorzugsweise vom Referenzstrom ($I_{ref}$) abhängigen Querstroms ($I_Q$), wobei der Querstrom ($I_Q$) einmal negativ und einmal positiv in die Summation im Stromsummationsknoten (S) (zusätzlich zum Referenzstrom und zum Vergleichstrom) eingeht.

**12.** Spannungskomparator nach einem der vorhergehenden Ansprüche,
**dadurch gekennzeichnet, dass**
die Ausgangsstufe (3) einen Schmitt-Trigger (ST) aufweist, dessen Eingang mit dem Stromsummationsknoten (S) verbunden ist.

**13.** Spannungskomparator nach einem der vorhergehenden Ansprüche,
**dadurch gekennzeichnet, dass**
die Bauelemente des Spannungskomparators auf einem Halbleiterchip integriert sind, wobei die Referenzspannung ($U_{ref}$) an einen Anschluss des Halbleiterchips anschließbar ist.

**14.** Spannungskomparator nach einem der vorhergehenden Ansprüche,
**dadurch gekennzeichnet, dass**
die Vergleichsspannung eine an zwei Eingängen ($IN_{-n}$, $IN_{-p}$) des Spannungskomparators anliegende Differenzspannung ($U_{diff}$) ist.

**15.** Spannungskomparator nach Anspruch 14,
**dadurch gekennzeichnet, dass**
der zweite Spannungs-Strom-Wandler zur Wandlung einer positiven und einer negativen Differenzspannung ausgebildet ist, wobei der zweite Spannungs-Strom-Wandler hierzu vorzugsweise einen ersten, der positiven Differenzspannung zugeordneten Stromspiegel und einen zweiten, der negativen Differenzspannung zugeordneten Stromspiegel aufweist.

**16.** Spannungskomparator nach einem der Ansprüche 14 oder 15,
**dadurch gekennzeichnet, dass**
der zweite Spannungs-Strom-Wandler (2) hochspannungsfest ausgebildet ist, indem dieser eine Durchbruchsspannungsfestigkeit aufweist, die signifikant über den Spannungswerten der Versorgungsspannung (VP) der Ausgangsstufe (3) oder der maximalen Referenzspannung ($U_{ref}$) liegt und an eine, an den zwei Eingängen ($IN_{-n}$, $IN_{-p}$) anlegbare maximale Gleichtakteingangsspannung angepasst ist.

**17.** Spannungskomparator nach einem der vorhergehenden Ansprüche,
**gekennzeichnet durch**
Mittel zur Abschaltung der Versorgungsspannung (VP) der Ausgangsstufe (3), so dass der Spannungskomparator zwischen einem Schlafmodus und einem Betriebsmodus schaltbar ist.

**18.** Verwendung eines Spannungskomparators nach einem der vorhergehenden Ansprüche innerhalb einer Schaltung zur Auswertung und/oder Überwachung einer mittels einer Ladungspumpe generierten Spannung.

**19.** Analog-Digital-Umsetzer insbesondere nach dem Wägeverfahren oder nach dem Zählverfahren zur Umsetzung von einem zeitlichen Vergleichsspannungsverlauf in digitale Ausgangssignale mit einem Spannungskomparator nach einem der Ansprüche 1 bis 17.

**Claims**

1. Voltage comparator for comparison of a comparison voltage ($U_{diff}$) with a threshold,

   - with a first voltage/current converter (1) for conversion of a reference voltage ($U_{ref}$), which determines the threshold, into a reference current ($I_{ref}$) dependent on the reference voltage ($U_{ref}$),
   - with a second voltage/current converter (2) for conversion of the comparison voltage ($U_{diff}$) into a comparison current ($I_V$) dependent on the comparison voltage ($U_{diff}$),
   - with an output stage (3) for output of a digital output level, wherein the output level is dependent on the reference current ($I_{ref}$) and the comparison current ($I_V$),
   - in which the output stage (3) is connected with a current summation junction (S), in which the comparison current ($I_V$) and a threshold current ($I_S$) dependent on the reference current ($I_{ref}$) are summated, wherein one of the two currents ($I_S$, $I_V$) enters the summation as a negative value,
   - with a voltage limiting means (MN1, MN6) for limitation of the voltage lying between the current summation junction (S) and the earth connection (GND, VN) of the output stage (3),
   - in which the current summation junction (S) is connected with the second voltage/current converter (2) by way of a transistor (MN1), wherein the transistor (MN1) acting as voltage limiting means has a higher breakdown voltage strength by comparison with the output stage (3).

2. Voltage comparator according to claim 1, **characterised by** means for multiplication of the reference current ($I_{ref}$) by a multiplication factor (m) so that the threshold current ($I_S$) entering the summation at the current summation junction (S) is dependent on the multiplication factor (m) and on the reference current ($I_{ref}$).

3. Voltage comparator according to claim 2, **characterised by** a reference current mirror (MN4, MN5, MN7, MN8), the current mirror ratio of which is settable, particularly switchable, as a means for multiplication.

4. Voltage comparator according to any one of the preceding claims, **characterised in that** the output level is determined by a potential in the current summation junction (6), which is dependent on the comparison current ($I_V$) and the threshold current ($I_S$).

5. Voltage comparator according to any one of the preceding claims, **characterised in that** the current summation junction (S) is connected by way of at least one further transistor (MN6) with a current mirror connected with the first voltage/current converter (1), wherein the further transistor (MN6) acting as voltage limiting means has a higher breakdown voltage strength by comparison with the output stage (3).

6. Voltage comparator according to claim 5, **characterised in that** the gate or the base of the further transistor (MN6) is connected or connectible with the supply voltage (VP) of the output stage (3).

7. Voltage comparator according to any one of the preceding claims, **characterised in that** the gate or the base of the second transistor (MN1) is connected or connectible with the supply voltage (VP) of the output stage (3).

8. Voltage comparator according to any one of the preceding claims, **characterised in that** the first voltage/current converter (1) and the second voltage/current converter (2) are arranged to be placed adjacent to one another or one in the other on a semiconductor chip.

9. Voltage comparator according to any one of the preceding claims, **characterised in that** the first voltage/current converter (1) and the second voltage/current converter (2) have the same components.

10. Voltage comparator according to any one of the preceding claims, **characterised in that** the first voltage/current converter (1) comprises a voltage mirror with at least one resistor (R3, R4) connected in series and/or the second voltage/current converter (2) comprises a current mirror with at least one resistor (R1, R2) connected in series.

11. Voltage comparator according to any one of the preceding claims, **characterised by** means for generating of a transverse current ($I_Q$) preferably dependent on the reference current ($I_{ref}$), wherein the transverse current ($I_Q$) enters once negatively and once positively into the summation at the current summation junction (S) (additionally to the reference current and to the comparison current).

12. Voltage comparator according to any one of the preceding claims, **characterised in that** the output stage (3) comprises a Schmitt trigger (ST), the input of which is connected with the current summation junction (S).

13. Voltage comparator according to any one of the preceding claims, **characterised in that** the components of the voltage comparator are integrated on a semiconductor chip, wherein the reference voltage ($U_{ref}$) is connectible to a terminal of the semiconductor chip.

**14.** Voltage comparator according to any one of the preceding claims, **characterised in that** the comparison voltage is a difference voltage ($U_{diff}$) applied to two inputs ($IN_{\_n}$, $IN_{\_p}$) of the voltage comparator.

**15.** Voltage comparator according to any one of the preceding claims, **characterised in that** the second voltage/current converter is constructed for conversion of a positive and a negative difference voltage, wherein the second voltage/current converter preferably has for this purpose a first current mirror associated with the positive difference voltage and a second current mirror associated with the negative difference voltage.

**16.** Voltage comparator according to one of claims 14 or 15, **characterised in that** the second voltage/current converter (2) is constructed to be resistant to high voltage and that this has a breakdown voltage strength which lies significantly above the voltage values of the supply voltage (VP) of the output stage (3) or of the maximum reference voltage ($U_{ref}$) and is matched to a maximum common-mode input voltage able to be applied to the two inputs ($IN_{\_n}$, $IN_{\_p}$).

**17.** Voltage comparator according to any one of the preceding claims, **characterised by** means for switching off the supply voltage (VP) of the output stage (3) so that the voltage comparator is switchable between a sleep mode and an operating mode.

**18.** Use of a voltage comparator according to any one of the preceding claims, within the circuit for evaluation and/or monitoring of a voltage generated by means of a charge pump.

**19.** Analog-to-digital converter particularly according to the weighing method or the counting method for conversion of a time comparison voltage plot into digital output signals by a voltage comparator according to any one of claims 1 to 17.


**Revendications**

**1.** Comparateur de tension pour comparer une tension de comparaison ($U_{diff}$) avec un seuil, comprenant:

. un premier convertisseur tension/intensité (1) pour convertir une tension de référence ($U_{ref}$) prédéterminée de seuil en un courant de référence ($I_{ref}$) dépendant de la tension de référence ($U_{ref}$),
. un second convertisseur tension/intensité (2) pour convertir la tension de comparaison ($U_{diff}$) en un courant de comparaison ($I_v$) dépendant de la tension de comparaison ($U_{diff}$),
. un étage de sortie (3) délivrant un signal numérique de sortie, dans lequel le signal de sortie est dépendant du courant de référence ($I_{ref}$) et de l'intensité de référence ($I_v$),
. l'étage de sortie étant relié à un noeud de sommation de courants (S), et dans lequel on additionne le courant de comparaison avec un courant de seuil ($I_s$) dépendant du courant de référence ($I_{ref}$) et dans lequel un des deux courants ($I_s$, $I_v$) est entré en tant que valeur négative dans la sommation,
. un limiteur de tension (MN1, MN6) pour limiter la tension de l'étage de sortie existant entre le noeud de sommation de courants (S) et la connexion de masse (GND, VN),
. le noeud de sommation de courants (S) est relié à travers un transistor (MN1) au second convertisseur tension/intensité (2) dans lequel le transistor (MN1) agissant en tant que moyen limiteur de tension présente une plus forte tension de claquage que l'étage de sortie (3).

**2.** Comparateur de tension selon la revendication 1 **caractérisé par** un moyen de multiplication du courant de référence ($I_{ref}$) par un facteur de multiplication (m) de façon que la valeur du courant de seuil ($I_s$) entrant en sommation dans le noeud de sommation de courant (S) soit dépendante du facteur de multiplication (m) et du courant de référence ($I_{ref}$).

**3.** Comparateur de tension selon la revendication 2 **caractérisé par** un circuit miroir de courant de référence (MN4, MN5, MN7, MN8) dont les caractéristiques de miroir de courant sont utilisées comme moyen réglable de multiplication, en particulier par commutation.

**4.** Comparateur de tension selon l'une des revendications précédentes **caractérisé en ce que** le niveau de sortie est harmonisé par un potentiel dans le noeud de sommation de courant (S) qui dépend du courant de comparaison ($I_v$) et du courant de seuil ($I_s$).

**5.** Comparateur de tension selon l'une des revendications précédentes **caractérisé en ce que** le noeud de sommation de courants (S) à au moins un transistor supplémentaire (MN6) avec un miroir de courant relié au premier convertisseur tension/intensité (1) et **en ce que** le transistor supplémentaire à fonction de moyen de limitation de tension présente une haute tension de claquage par rapport à l'étage de sortie (3).

**6.** Comparateur de tension selon la revendication 5 **caractérisé en ce que** la porte, respectivement la base, du transistor supplémentaire (MN6) est reliée ou peut être reliée à la tension d'alimentation (VP) de l'étage de sortie.

**7.** Comparateur de tension selon l'une des revendications précédentes **caractérisé en ce que** la porte, respectivement la base, du deuxième transistor (MN1) est soumise ou peut être soumise à la tension d'alimentation de l'étage de sortie (3).

**8.** Comparateur de tension selon l'une des revendications précédentes **caractérisé en ce que** le premier convertisseur tension/intensité (1) et le second convertisseur tension/intensité (2) sont placés l'un à côté de l'autre ou l'un dans l'autre sur une plaquette semi-conductrice.

**9.** Comparateur de tension selon l'une des revendications précédentes **caractérisé en ce que** le premier convertisseur tension/intensité (1) et le second convertisseur tension/intensité (2) présentent des composants identiques.

**10.** Comparateur de tension selon l'une des revendications précédentes **caractérisé en ce que** le premier convertisseur tension/intensité (1) présente un miroir de courant avec au moins une résistance (R3,R4) en série dans le circuit et/ou le second convertisseur tension/intensité (2) présente un miroir de courant avec au moins une résistance (R1,R2) en série.

**11.** Comparateur de tension selon l'une des revendications précédentes **caractérisé par** un moyen de génération d'un courant transversal ($I_Q$) dépendant de préférence du courant de référence ($I_{ref}$), le courant transversal ($I_Q$) entrant une fois en polarité négative et une autre fois en polarité positive dans la sommation dans le noeud de sommation de courants (S) en complément du courant de référence et du courant de comparaison.

**12.** Comparateur de tension selon l'une des revendications précédentes **caractérisé en ce que** l'étage de sortie (3) présente un trigger de SCHMITT (ST) dont l'entrée est reliée au noeud de sommation (S).

**13.** Comparateur de tension selon l'une des revendications précédentes **caractérisé en ce que** les composants du comparateur de tension sont intégrés à une plaquette de semi-conducteurs, la tension de référence ($U_{ref}$) étant branchée à une connexion de la plaquette de semi-conducteurs.

**14.** Comparateur de tension selon l'une des revendications précédentes **caractérisé en ce que** la tension de comparaison est l'une des tensions différentielles ($U_{diff}$) qui se trouve aux deux entrées ($IN_n$, $IN_p$) du comparateur de tension.

**15.** Comparateur de tension selon la revendication 14 **caractérisé en ce que** le second convertisseur tension/intensité est prévu pour convertir une tension différentielle positive et négative, **en ce que** le second convertisseur tension/intensité présente de préférence un premier miroir de courant pour la tension différentielle positive et un second miroir de courant pour la tension différentielle négative.

**16.** Comparateur de tension selon la revendication 14 ou 15 **caractérisé en ce que** le second convertisseur tension (2) est résistant à la haute tension, celui-ci présentant une tension de claquage qui est significativement plus élevée que les valeurs de la tension d'alimentation (VP) de l'étage de sortie (3) et les valeurs maximales de la tension de référence ($U_{ref}$) et qui est ajustée à la tension d'entrée maximale qui pourrait se trouver simultanément sur les deux entrées ($IN_n$, $IN_p$).

**17.** Comparateur de tension selon l'une des revendications précédentes **caractérisé par** un moyen de déconnexion de la tension d'alimentation (VP), à l'étage de sortie (3) de façon que le comparateur de tension puisse être commuté entre un mode de repos et un mode de fonctionnement.

**18.** Utilisation d'un comparateur de tension selon l'une des revendications précédentes dans un circuit pour l'évaluation et/ou la surveillance d'une tension générée par une pompe de charge.

**19.** Convertisseur analogique/numérique en particulier dans les procédés de pesage ou de comptage pour convertir simultanément une comparaison de tension en des signaux de sortie numériques avec un comparateur de tension selon l'une des revendications 1 à 17.

FIG.1

FIG.2

**EP 1 624 567 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5512849 A

- DE 19911098 A1